# FASCICULE DE BREVET EUROPEEN

(11) **EP 2 419 902 B1**
(45) Date de publication et mention de la délivrance du brevet: **18.09.2019**
(21) Numéro de dépôt: 10723670.5
(22) Date de dépôt: 13.04.2010
(51) Int. Cl.: G11C 11/404, H01L 21/84, H01L 27/108, H01L 27/12

(54) **POINT MEMOIRE RAM A UN TRANSISTOR**
RAM-SPEICHERELEMENT MIT EINEM TRANSISTOR
RAM MEMORY ELEMENT WITH ONE TRANSISTOR

(30) Priorité: 15.04.2009 FR 0952452
(43) Date de publication de la demande: 22.02.2012
(73) Titulaire: Centre National de la Recherche Scientifique, 75794 Paris Cedex 16 (FR); Universidad de Granada, 18071 Granada (ES)
(72) Inventeur: CRISTOLOVEANU, Sorin, Ioan, F-38170 Seyssinet (FR); RODRIGUEZ, Noel, E-18.100 Armilla (granada) (ES); GAMIZ, Francisco, E-18.100 Armilla (granada) (ES)
(74) Mandataire: Lavoix
(86) Numéro de dépôt international: PCT/FR2010/050716
(87) Numéro de publication internationale: WO 2010/119224

(56) Documents cités:
- EP-A2- 2 206 143
- WO-A1-88/08617
- US-A1- 2004 022 105
- US-A1- 2004 041 208
- US-A1- 2004 155 317
- US-A1- 2007 007 574
- US-A1- 2008 203 403

## Description

### Domaine de l'invention

La présente invention concerne un point mémoire RAM à un transistor.

### Exposé de l'art antérieur

Historiquement, les points mémoire DRAM ont été constitués d'un ensemble comprenant un transistor MOS et un condensateur. Avec la miniaturisation des circuits intégrés, les transistors MOS ont pu avoir des dimensions de plus en plus petites et la difficulté a consisté à réduire la taille des condensateurs. Pour pallier cette difficulté, on a proposé des points mémoire constitués d'un unique transistor, sans condensateur, le transistor MOS étant à corps isolé par jonction, ou à corps isolé par isolant dans des technologies de type semiconducteur sur isolant (SOI ou Semiconductor On Insulator) ou semiconducteur sur rien (SON ou Semiconductor On Nothing). Dans ces points mémoire, la mémorisation correspond à un stockage de charges dans le transistor. Ceci a conduit à une miniaturisation accrue des cellules DRAM. Toutefois, les divers points mémoire sans condensateur connus souffrent généralement d'au moins l'un des inconvénients suivants : durée de rétention limitée, consommation élevée, faible différenciation entre les deux états de mémorisation, complexité de commande, utilisation de deux grilles, faible vitesse de fonctionnement, impossibilité de réduire l'épaisseur du corps du transistor qui doit assurer la présence simultanée d'électrons et de trous, et/ou difficulté de fabrication.

US2004/0041208, US2004/0155317, US2008/0203403 et US2007/007574 donnent des exemples de divers points mémoire DRAM à un transistor MOS et à un condensateur présentant l'un ou l'autre des divers inconvénients susmentionnés. La demande de brevet européen EP2206143 opposable au titre de l'Article 54(3)CBE, divulgue un point mémoire constitué d'un transistor MOS à deux régions de canal séparées par un isolant s'étendant parallèlement au plan de la grille.

### Résumé

Ainsi, un objet de l'invention est de prévoir un point mémoire RAM à un seul transistor, sans condensateur, qui pallie au moins certains des inconvénients des points mémoire à transistor unique connus.

Ainsi, un premier mode de réalisation de la présente invention prévoit un point mémoire constitué d'un transistor MOS ayant un drain, une source et une région de corps revêtue d'une grille isolée, dans lequel la région de corps est divisée dans son épaisseur en deux régions distinctes séparées par une portion de couche isolante s'étendant parallèlement au plan de la grille, la région de canal la plus proche de la grille ayant une épaisseur de 5 à 50 nm, de préférence de 5 à 20 nm.

Selon un mode de réalisation de la présente invention, les deux régions distinctes sont du même type de conductivité.

Selon un mode de réalisation de la présente invention, les deux régions distinctes sont de types de conductivité opposés.

Selon un mode de réalisation de la présente invention, le point mémoire est réalisé à partir d'une structure SOI.

Selon un mode de réalisation de la présente invention, le point mémoire est réalisé à partir d'une structure FINFET.

Selon un mode de réalisation de la présente invention, la portion de couche isolante a une épaisseur de l'ordre de 1 à 10 nanomètres, de préférence de 1 à 3 nanomètres.

Selon un mode de réalisation de la présente invention, la région de corps la plus proche de la grille a une épaisseur de 5 à 50 nm, de préférence de 5 à 20 nm.

Selon un mode de réalisation de la présente invention, le point mémoire comprend en outre une deuxième grille isolée sous la région de corps.

Selon un mode de réalisation de la présente invention, le transistor MOS est isolé par une couche isolante.

Selon un mode de réalisation de la présente invention, le transistor MOS est formé directement sur un substrat de type de conductivité opposé à celui de ses drain/source.

Un second mode de réalisation de la présente invention prévoit un point mémoire constitué d'un transistor MOS ayant un drain, une source et une région de corps revêtue d'une grille isolée, dans lequel la région de corps est divisée dans son épaisseur en deux régions de canal distinctes séparées par une portion de couche isolante s'étendant parallèlement au plan de la grille, dans lequel la région de corps comprend une troisième région séparée des deux régions de canal distinctes susmentionnées par une portion de couche isolante s'étendant parallèlement au plan de la grille et ayant sensiblement la même étendue que la portion de couche isolante s'étendant entre les deux premières régions distinctes, et une deuxième grille est disposée en regard de la troisième région distincte, à l'opposé de la première grille.

Dans le cas où le point mémoire est un point mémoire comme dans le premier mode de réalisation de la présente invention avec deux régions de canal, où la tension de source est considérée comme la tension de référence et les régions de source et de drain sont de type N, il est prévu un procédé d'utilisation comprenant, dans un ordre quelconque, les étapes suivantes :
écriture d'un 1 : application d'une tension positive sur le drain et, pendant l'application de cette tension positive, application d'une brève tension positive sur la grille,
écriture d'un 0 : application d'une tension très faiblement positive, nulle ou négative sur le drain et application d'une tension positive sur la grille,
lecture : application d'une tension négative sur la grille et d'une tension faiblement positive sur le drain, et
maintien : application d'une tension négative sur la grille et d'une tension faiblement positive ou nulle sur le drain.

Dans le cas où la tension de source est considérée comme la tension de référence et les régions de source et de drain sont de type N, et où le point mémoire est un point mémoire à quatre états à trois régions de corps, il est prévu un procédé d'utilisation comprenant, dans un ordre quelconque, les étapes suivantes :
écriture d'un état (11) : application d'une tension positive sur le drain et, pendant l'application de cette tension positive, application d'une brève tension positive sur les deux grilles,
écriture d'un état (00) : application d'une tension très faiblement positive, nulle ou négative sur le drain et application d'une tension positive sur les deux grilles,
écriture d'un état (01) ou (10) : application d'une tension positive sur le drain et, pendant l'application de cette tension positive, application d'une brève tension positive sur l'une des grilles, puis application d'une tension très faiblement positive, nulle ou négative sur le drain et application d'une tension positive sur l'autre grille,
lecture : application d'une tension négative sur les grilles et d'une tension faiblement positive sur le drain, et
maintien : application d'une tension négative sur les grilles et d'une tension faiblement positive ou nulle sur le drain.

### Brève description des dessins

Ces objets, caractéristiques et avantages, ainsi que d'autres seront exposés en détail dans la description suivante de modes de réalisation particuliers faite à titre non-limitatif en relation avec les figures jointes parmi lesquelles :
la figure 1 est une vue en coupe schématique d'un point mémoire selon un mode de réalisation de la présente invention ;
les figures 2A et 2B illustrent l'écriture d'un 1 dans un point mémoire selon un mode de réalisation de la présente invention ;
la figure 3 illustre l'écriture d'un 0 dans un point mémoire selon un mode de réalisation de la présente invention ;
les figures 4A et 4B illustrent la lecture, respectivement d'un 0 et d'un 1, dans un point mémoire selon un mode de réalisation de la présente invention ;
les figures 5A, 5B, 5C illustrent des tensions appliquées, respectivement pour l'écriture d'un 1, l'écriture d'un 0, et la lecture dans un point mémoire selon un mode de réalisation de la présente invention ;
les figures 6A à 6D sont des vues en coupe schématiques illustrant des étapes successives d'un exemple de fabrication d'un point mémoire du type de celui de la figure 1 ;
les figures 7A et 7B sont des vues schématiques en coupe et en perspective de variantes d'un point mémoire selon la présente invention ;
la figure 8 représente une autre variante d'un point mémoire selon un mode de réalisation de la présente invention ; et
la figure 9 est une vue en coupe schématique et en perspective d'une autre variante d'un point mémoire selon un mode de réalisation de la présente invention.

Par souci de clarté, de mêmes éléments ont été désignés par de mêmes références aux différentes figures et, comme cela est habituel dans la représentation des circuits intégrés, les diverses figures ne sont pas tracées à l'échelle.

### Description détaillée

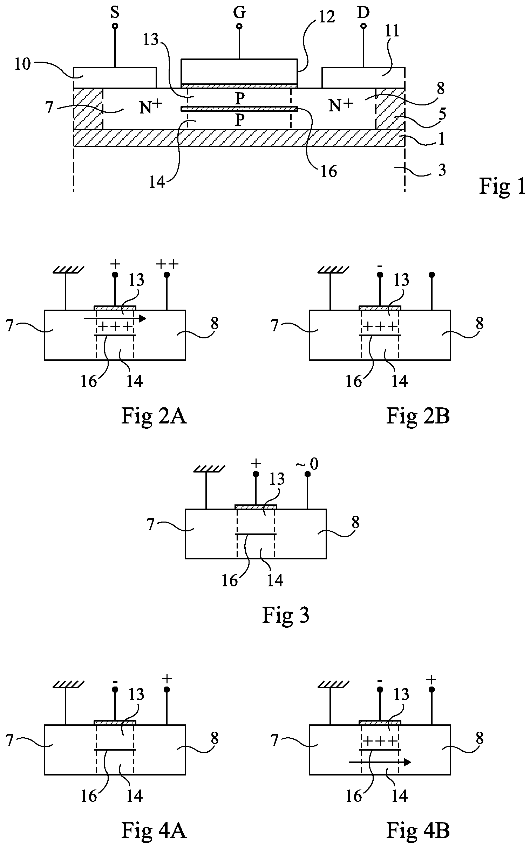

La figure 1 est une vue en coupe illustrant un point mémoire sans condensateur. Ce point mémoire comprend un transistor MOS formé sur une couche isolante 1 reposant sur un support 3, généralement une plaque de silicium. La zone occupée par le transistor MOS, ou zone active, est délimitée par une périphérie isolante 5. Le transistor MOS comprend des régions de source et de drain fortement dopées d'un premier type de conductivité 7 et 8 séparées par une région de corps faiblement dopée du deuxième type de conductivité. Dans ce qui suit, on considérera que le premier type de conductivité est le type N et que le second type de conductivité est le type P, bien que cela ne doive pas être considéré comme limitatif. Les régions de source et de drain sont respectivement solidaires d'une métallisation de source 10 et d'une métallisation de drain 11 reliées à des bornes de source S et de drain D. La partie de corps du transistor est surmontée d'une grille isolée 12 reliée à une borne de grille G. La région de corps est divisée dans le sens de son épaisseur en une région de corps supérieure 13 du côté de la grille 12 et une région de corps inférieure 14 au voisinage de la couche isolante 1. Les régions de corps supérieure et inférieure sont séparées par une couche isolante 16.

La structure de la figure 1 sera de préférence réalisée en utilisant des technologies permettant d'obtenir des épaisseurs de couche avec une précision meilleure que 5 nm, de préférence de l'ordre du nm. On choisira également des technologies dans lesquelles les dimensions latérales peuvent être définies avec des valeurs minimales inférieures à 50 nm. Dans ces conditions, on choisit de réaliser une structure dans laquelle l'épaisseur totale du transistor est inférieure à 100 nm, la région de corps supérieure ayant une épaisseur de 5 à 50 nm, de préférence voisine de 10 nm, et la région de corps inférieure ayant une épaisseur de 5 à 50 nm, la région de corps supérieure et la région de corps inférieure étant séparées par une couche isolante 16 d'une épaisseur de 1 à 10 nm, par exemple de l'ordre de 3 nm. La longueur de canal du transistor sera de préférence inférieure à 65 nm, par exemple 35 nm.

La façon dont la structure de la figure 1 peut être utilisée en point mémoire va maintenant être décrite en relation avec les figures 2 à 4.

Les figures 2A et 2B illustrent des étapes d'écriture d'un 1 dans le point mémoire de la figure 1. Dans ce qui suit, on supposera que la source S est en permanence connectée à une tension de référence qui est désignée par souci de simplicité comme étant la masse.

Pour écrire un 1, on applique d'abord comme l'illustre la figure 2A une tension positive relativement élevée, par exemple 1 à 3 volts, sur le drain du transistor, et la grille est mise à un potentiel positif pendant une courte durée, pendant que la tension positive est appliquée sur le drain. Il en résulte qu'une région de canal est formée dans la région de corps supérieure (et pas dans la région de corps inférieure qui est trop éloignée de la grille) et que des électrons circulent de la source au drain. Etant donné que la différence de potentiel drain-source est choisie relativement élevée, ces électrons vont créer par impact des paires électrons-trous dans la région de corps supérieure. Les électrons créés participent à la circulation de courant et les trous demeurent dans la région de corps supérieure. Si on interrompt brutalement (figure 2B) le passage de courant entre source et drain, en commutant la grille à un potentiel négatif avant de commuter le drain, des trous désignés par des signes + en figures 2A et 2B, demeureront dans la région de corps supérieure 13.

La figure 3 illustre l'écriture d'un 0 dans le point mémoire. A nouveau, on rend la grille positive mais cette fois-ci, on connecte le drain 8 à une tension faiblement positive, nulle ou même négative. Alors, la différence de potentiel source drain est insuffisante pour assurer la création de paires électrons-trous, et, en raison de la polarisation électrostatique créée par la grille dans la région de corps supérieure 13, les trous éventuellement présents dans cette région de corps supérieure seront évacués vers le drain et/ou la source. Ainsi, les états de la figure 2B et de la figure 3 se différencient par le fait que dans un cas (écriture d'un 1) des trous sont stockés dans la région de corps supérieure 13 et que dans le deuxième cas (écriture d'un 0), aucune charge n'est stockée dans cette région de corps supérieure.

Les figures 4A et 4B illustrent respectivement la lecture d'un 0 et la lecture d'un 1 dans le point mémoire de la figure 1. En phase de lecture (ou de rétention), on maintient une tension négative sur la grille et une tension faiblement positive sur le drain.

Comme l'illustre la figure 4A, dans le cas où un 0 a été mémorisé, c'est-à-dire qu'aucune charge n'est stockée dans la région de corps supérieure 13, les transistors en parallèle partageant un même drain et une même source sont tous deux bloqués : il ne passe pas de courant dans le transistor correspondant à la région de corps supérieure puisque la grille est négative, et il n'y a aucune raison qu'il passe du courant dans le transistor correspondant à la région de corps inférieure puisque rien n'est susceptible d'y créer un canal d'électrons.

Par contre, comme l'illustre la figure 4B, dans le cas où un 1 a été écrit, c'est-à-dire que des charges positives sont stockées dans la région de corps supérieure 13, aucun courant ne circule dans le transistor correspondant à cette région de corps supérieure puisque la grille est négative et qu'il n'est pas créé de région de canal d'électrons dans cette région de corps supérieure. Par contre, les charges positives stockées dans la région de corps supérieure induisent par couplage électrostatique une région de canal dans la région de corps inférieure et un courant va circuler dans le transistor ayant pour source et drain les régions 7 et 8 et comme corps cette région de corps inférieure. On comprendra que la région de corps supérieure doit être suffisamment mince pour que les charges stockées, attirées du côté de la grille, aient une influence électrostatique suffisante sur la région de corps inférieure, c'est pourquoi on a indiqué que cette région de corps supérieure avait une épaisseur de préférence voisine de 10 nm.

Ainsi, on pourra reconnaître un état 1 d'un état 0 par la circulation d'un courant ou l'absence de circulation d'un courant lors d'une phase de lecture. On remarquera que ces deux états sont très bien différenciés car, pendant la lecture d'un 0, il ne circule absolument aucun courant entre drain et source. L'absence totale de circulation de courant pendant la présence d'un état 0, fait que le dispositif présente un temps de rétention très long puisque, même si pendant la lecture d'un état 1 il se produit une légère perte des charges stockées dans la région de corps supérieure, il existera toujours une nette différenciation entre les états 0 et 1.

On notera également que, du fait que pendant l'état de lecture seul un potentiel faiblement positif est appliqué sur le drain, il ne se crée pas de charges par impact dans la région de corps inférieure 14 pendant une lecture.

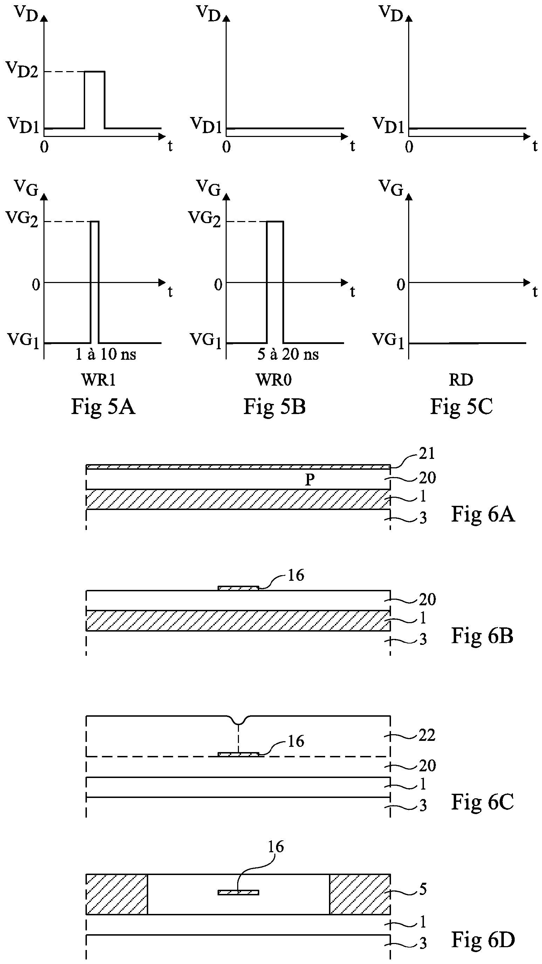

Pour mieux illustrer le fonctionnement du point mémoire, chacune des figures 5A, 5B et 5C représente l'allure des tensions de drain (VD) et de grille (VG), respectivement pendant les états d'écriture d'un 1 (WR1), d'écriture d'un 0 (WR0) et de lecture (RD). Pendant l'écriture d'un 1 (figure 5A), la tension de drain est amenée à passer d'une tension nulle ou faiblement positive VD1, par exemple 0,1 V, à une tension VD2 nettement positive, par exemple 1 à 2,2 V et, pendant la période (par exemple 5 à 30 ns) durant laquelle la tension de drain VD2 est appliquée, la grille est brièvement (par exemple pendant 1 à 10 ns) amenée d'une valeur négative VG1 à une valeur positive VG2, par exemple de -1,2 volt à + 1 volt. Pour l'écriture d'un zéro (figure 5B), la tension de drain est maintenue à la valeur basse VD1 et la grille est amenée pendant une courte période, par exemple de l'ordre de 1 à 10 nanosecondes à une valeur positive pour permettre l'évacuation de charges éventuellement présentes dans la région de corps supérieure. Dans l'état de lecture, ou de rétention (figure 5C), le drain est maintenu à la valeur faible de tension VD1 et la grille est maintenue à sa valeur négative VG1.

Le mode d'application de tensions décrit en relation avec les figures 5A à 5C est particulièrement avantageux car il ne prévoit que deux niveaux de tension possibles sur la grille et sur le drain. On pourra toutefois prévoir des modes de commutation de tension plus complexes, dans lesquels par exemple, la tension de drain serait commutable entre plus de deux niveaux de tension, par exemple un troisième niveau de tension nul ou négatif pendant la phase d'écriture d'un 0, ou un niveau de tension nul pendant la phase de rétention. Pendant les phases d'écriture d'un 1, au lieu de créer des trous par ionisation par impact, on pourra utiliser d'autres phénomènes. En appliquant une tension fortement négative (par exemple -2,5 V) à la grille, et une tension positive au drain, des trous seront créés par effet tunnel bande à bande (B to B tunelling) ou par activation du transistor bipolaire parasite.

On notera que les valeurs de tension indiquées ci-dessus sont purement indicatives et sont données pour un point mémoire ayant sensiblement les dimensions indiquées précédemment. L'homme de l'art saura adapter ces valeurs aux caractéristiques spécifiques d'un composant particulier.

Les figures 6A à 6D illustrent des étapes possibles de réalisation d'une structure telle que celle de la figure 1.

Comme l'illustre la figure 6A, on part d'une structure de type SOI comprenant, sur un support 3 revêtu d'une couche isolante 1, un substrat 20 faiblement dopé de type P sur lequel est formé, par exemple par oxydation thermique, une mince couche isolante 21.

A l'étape illustrée en figure 6B, la couche isolante 21 est gravée pour former les couches de séparation 16 mentionnées lors de la description de la figure 1.

A l'étape illustrée en figure 6C, on fait croître par épitaxie une couche 22 faiblement dopée de type P. De façon connue, l'épitaxie se développera à partir de la surface apparente de la couche 20 et se refermera au-dessus de la couche 16. De préférence, cette croissance par épitaxie est poursuivie jusqu'à une épaisseur supérieure à l'épaisseur souhaitée pour la région de corps 13 et on procède à un amincissement pour réduire cette épaisseur.

Ensuite, ou lors d'une étape intermédiaire, comme l'illustre la figure 6D, on forme la périphérie isolante 5 entourant la zone active désirée puis on procède aux étapes classiques de formation d'un oxyde de grille, d'une grille et des régions de source-drain (non représentées).

Ce qui a été décrit ci-dessus ne constitue qu'un exemple possible de réalisation d'une structure du type de celle de la figure 1. D'autres modes de réalisation sont envisageables. Par exemple, on pourra partir d'un sandwich sur isolant comprenant successivement une couche de silicium de type P, une couche de silicium-germanium et une couche de silicium de type P, la couche de silicium-germanium ayant été conformée selon les dimensions de la couche isolante 16 puis on pourra procéder à une sous-gravure de la couche de silicium germanium et à un remplissage par un isolant de la cavité ainsi formée. On pourra aussi utiliser des techniques de collage de plaquettes.

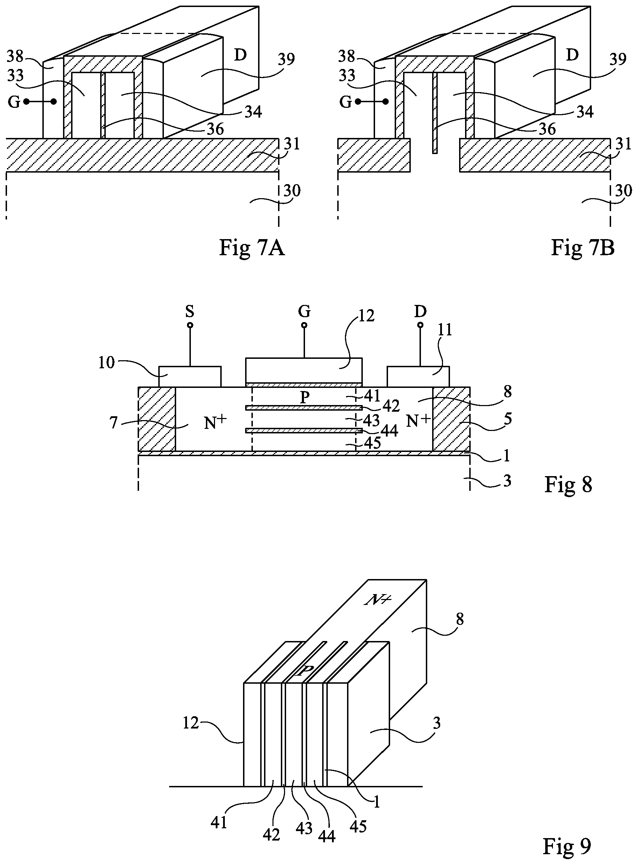

Le point mémoire décrit ci-dessus est susceptible de nombreuses variantes et modifications. Les figures 7A et 7B illustrent des réalisations selon une configuration généralement appelée dans la technique structure FINFET (transistor à effet de champ à structure en ailette). Ces figures sont des vues en coupe et en perspective de la partie de corps et de la partie de drain de la structure, la partie de source, non représentée, étant en avant du plan de la figure. Une excroissance de silicium en ailette est formée au-dessus d'une plaquette 30 revêtue d'une couche isolante 31. Cette excroissance est divisée en une partie gauche 33 et une partie droite 34 correspondant respectivement à la région de corps supérieure 13 et à la région de corps inférieure 14 de la figure 1, la séparation étant assurée par un isolant 36. Des métallisations de grilles isolées 38 et 39 sont disposées de part et d'autre de l'ailette, en regard du corps de gauche 33 et du corps de droite 34. En figure 7A, les régions de corps 33 et 34 sont isolées de la plaquette 30 par la couche 31. En figure 7B, il y a continuité entre les régions de corps 33 et la plaquette 30. On comprendra que cette structure fonctionne de la même façon que la structure de la figure 1 si on utilise une seule des deux grilles.

Les deux grilles 38 et 39 pourraient être utilisées pour inverser sélectivement les fonctions des corps de gauche et de droite. De même, dans la structure de la figure 1, on pourrait prévoir de polariser sélectivement le support 3 pour agir sur la région de corps inférieure 14 à travers la couche isolante 1, par exemple pour ajuster la tension de seuil du transistor inférieur. On pourra aussi ajouter une grille inférieure.

La figure 8 représente une autre variante de la structure de la figure 1. De mêmes éléments sont désignés par de mêmes références. Le corps du transistor, au lieu d'être divisé en deux régions dans le sens de son épaisseur, est divisé en trois régions : une région supérieure 41 séparée par un isolant 42 d'une région centrale 43 elle-même séparée par un isolant 44 d'une région inférieure 45. Ainsi, à condition de prévoir une possibilité de polarisation du support 3, on obtient un point mémoire bibit, c'est-à-dire un point mémoire à quatre états. La grille supérieure permet comme cela a été décrit précédemment de stocker ou non des charges dans la région de corps supérieure 41. La grille inférieure, correspondant à la région de support 3, permet de stocker ou non des charges dans la région de corps inférieure 45. On obtient un premier état (11) si des charges sont stockées en haut et en bas, un deuxième état (00) si aucune charge n'est stockée ni dans la partie supérieure ni dans la partie inférieure, un troisième état (10) si des charges sont stockées dans la partie supérieure et pas dans la région de corps inférieure et un quatrième état (01) si des charges sont stockées dans la région de corps inférieure et pas dans la région de corps supérieure. Les états (01) et (10) pourront être différenciés de diverses manières. Notamment, si les grilles supérieure ou inférieure sont différentes (travail de sortie différent ou épaisseur d'isolant différente) et/ou si les tensions appliquées sont différentes, on stockera à chaque écriture d'un 1 une quantité plus ou moins grande de charges dans la région de corps supérieure et dans la région de corps inférieure. Ainsi, les quatre valeurs possibles du courant dans la région de corps centrale peuvent être bien différenciées.

La figure 9 illustre très schématiquement une réalisation FINFET de la structure de la figure 8. Cette figure ne sera pas décrite en détail, des éléments ayant les mêmes fonctions que ceux de la figure 8 étant désignés par de mêmes références.

Des modes de réalisation particuliers de la présente invention ont été décrits. Diverses variantes et modifications apparaîtront à l'homme de l'art. En particulier, diverses variantes de réalisation de transistors MOS pourront être adoptées, par exemple la réalisation de zones de source et de drain faiblement dopées (LDD) au voisinage de la région de canal.

On comprendra également que le fait que l'on ait appelé état 1 l'un des états de mémorisation et état 0 l'autre des états de mémorisation est parfaitement arbitraire.

Dans ce qui a été décrit précédemment, on utilise un transistor à deux corps séparés par un diélectrique : un corps susceptible de stocker des charges d'une première polarité et un corps susceptible de laisser passer des charges de polarité opposée. Il n'y a donc pas de coexistence de charges de polarités opposées dans un même corps. Ceci est l'une des raisons principales pour lesquelles la structure décrite évite les inconvénients susmentionnés des points mémoire à un transistor de l'art antérieur (durée de rétention limitée, consommation élevée, faible différenciation entre les deux états de mémorisation, complexité de commande, faible vitesse de fonctionnement, impossibilité de réduire l'épaisseur du corps du transistor qui doit assurer la présence simultanée d'électrons et de trous). De plus le dispositif décrit peut fonctionner avec une seule grille et est relativement simple à commander.

Divers modes de réalisation et diverses variantes d'un point mémoire à un seul transistor ont été décrits ici. L'homme de l'art pourra combiner divers éléments de ces divers modes de réalisation et variantes sans faire preuve d'activité inventive.

En particulier, dans le mode de réalisation décrit en détail ci-dessus, le transistor MOS est isolé par une couche isolante 1. On pourrait prévoir que ce transistor MOS soit formé directement au-dessus d'un substrat de silicium de type de conductivité opposé à celui des régions de drain/source, à savoir un substrat de type P si les régions de drain/source sont de type N.

Par ailleurs, dans le mode de réalisation décrit en détail ci-dessus, la partie inférieure 14 de la région de corps, sous la portion de couche isolante 16 est du même type de conductivité P que la partie supérieure 13. Selon une variante elle pourrait être de type de conductivité opposé, à savoir de type N. Le niveau de dopage de la partie inférieure 14 sera alors de préférence choisi dans une plage de 10¹⁶ à 10¹⁸ atomes/cm³ en fonction de son épaisseur de façon que cette partie inférieure 14 soit complètement déplétée à l'état 0 et qu'elle contienne suffisamment d'électrons disponibles à l'état 1. Alors, pendant un état de maintien, si le point mémoire est programmé à 0, cette partie inférieure 14 de type N de la région de corps sera déplétée par le potentiel de grille négatif et aucun courant ne pourra circuler de la source au drain à travers cette partie. De même, dans le mode de réalisation des figures 8 et 9, la région centrale se type N pourrait être dopée de type N dans les mêmes conditions.

## Revendications

1. Point mémoire constitué d'un transistor MOS ayant un drain (8), une source (7) et une région de corps revêtue d'une grille isolée (12), dans lequel la région de corps est divisée dans son épaisseur en deux régions de canal distinctes (13, 14) séparées par une portion de couche isolante (16) s'étendant parallèlement au plan de la grille, la région de canal (13) la plus proche de la grille (12) ayant une épaisseur de 5 à 50 nm, de préférence de 5 à 20 nm.

2. Point mémoire selon la revendication 1, dans lequel les deux régions distinctes (13,14) sont du même type de conductivité.

3. Point mémoire selon la revendication 1, dans lequel les deux régions distinctes (13,14) sont de types de conductivité opposés.

4. Point mémoire selon la revendication 1, réalisé à partir d'une structure SOI.

5. Point mémoire selon la revendication 1, réalisé à partir d'une structure FINFET.

6. Point mémoire selon l'une quelconque des revendications 1 à 5, dans lequel la portion de couche isolante (16) a une épaisseur de l'ordre de 1 à 10 nanomètres, de préférence de 1 à 3 nanomètres.

7. Point mémoire selon l'une quelconque des revendications 1 à 6, comprenant en outre une deuxième grille isolée sous la région de corps.

8. Point mémoire selon l'une quelconque des revendications 1 à 7, dans lequel le transistor MOS est isolé par une couche isolante (1).

9. Point mémoire selon l'une quelconque des revendications 1 à 6, dans lequel le transistor MOS est formé directement sur un substrat de type de conductivité opposé à celui de ses drain/source.

10. Point mémoire constitué d'un transistor MOS ayant un drain (8), une source (7) et une région de corps revêtue d'une grille isolée (12), dans lequel la région de corps est divisée dans son épaisseur en deux régions de canal distinctes (41,43) séparées par une portion de couche isolante (42) s'étendant parallèlement au plan de la grille, dans lequel la région de corps comprend une troisième région de canal (45) séparée des deux régions de canal distinctes susmentionnées par une portion de couche isolante (44) s'étendant parallèlement au plan de la grille et ayant sensiblement la même étendue que la portion de couche isolante s'étendant entre les deux premières régions distinctes, et dans lequel une deuxième grille (3) est disposée en regard de la troisième région distincte, à l'opposé de la première grille.

11. Procédé d'utilisation d'un point mémoire selon l'une quelconque des revendications 1 à 9, dans lequel la tension de source est considérée comme la tension de référence et les régions de source (7) et de drain (8) sont de type N, ledit procédé comprenant, dans un ordre quelconque, les étapes suivantes :
écriture d'un 1 : application d'une première tension positive sur le drain (8) et, pendant une partie de l'application de cette première tension positive, application d'une deuxième tension positive sur la grille (12),
écriture d'un 0 : application d'une troisième tension très faiblement positive, nulle ou négative sur le drain et application d'une quatrième tension positive sur la grille,
lecture : application d'une cinquième tension négative sur la grille et d'une sixième tension positive sur le drain, et
maintien : application d'une septième tension négative sur la grille et d'une huitième tension positive ou nulle sur le drain.

12. Procédé d'utilisation d'un point mémoire à quatre états selon la revendication 10, dans lequel la tension de source est considérée comme la tension de référence et les régions de source (7) et de drain (8) sont de type N, ce procédé comprenant, dans un ordre quelconque, les étapes suivantes :
écriture d'un état (11) : application d'une première tension positive sur le drain (8) et, pendant une partie de l'application de cette première tension positive, application d'une deuxième tension positive sur les deux grilles,
écriture d'un état (00) : application d'une troisième tension très faiblement positive, nulle ou négative sur le drain (8) et application d'une quatrième tension positive sur les deux grilles,
écriture d'un état (01) ou (10) : application d'une cinquième tension positive sur le drain et, pendant une partie de l'application de cette tension positive, application d'une sixième tension positive sur l'une des grilles, puis application d'une septième tension très faiblement positive, nulle ou négative sur le drain (8) et application d'une huitième tension positive sur l'autre grille,
lecture : application d'une tension négative sur les grilles et d'une neuvième tension positive sur le drain, et
maintien : application d'une dixième tension négative sur les grilles et d'une onzième tension faiblement positive ou nulle sur le drain (8).

## Patentansprüche

1. Speicherzelle, gebildet aus einem MOS-Transistor mit einer Drain (8), einer Source (7) und einem Body-Bereich, der mit einem isolierten Gate (12) beschichtet ist, wobei der Body-Bereich in seiner Dicke in zwei unterschiedliche Kanalbereiche unterteilt ist (13, 14), die durch einen Isolierschichtabschnitt (16) getrennt sind, der sich parallel zur Ebene des Gates erstreckt, wobei der Kanalbereich (13), der dem Gate (12) am nächsten liegt, eine Dicke von 5 bis 50 nm, vorzugsweise 5 bis 20 nm hat.

2. Speicherzelle nach Anspruch 1, wobei die zwei unterschiedlichen Bereiche (13, 14) vom gleichen Leitfähigkeitstyp sind.

3. Speicherzelle nach Anspruch 1, wobei die zwei unterschiedlichen Bereiche (13, 14) von entgegengesetzten Leitfähigkeitstypen sind.

4. Speicherzelle nach Anspruch 1, hergestellt aus einer SOI-Struktur.

5. Speicherzelle nach Anspruch 1, hergestellt aus einer FINFET-Struktur.

6. Speicherzelle nach einem der Ansprüche 1 bis 5, wobei der Isolierschichtabschnitt (16) eine Dicke in der Größenordnung von 1 bis 10 Nanometern, vorzugsweise 1 bis 3 Nanometern aufweist.

7. Speicherzelle nach einem der Ansprüche 1 bis 6, ferner aufweisend ein zweites isoliertes Gate unter dem Body-Bereich.

8. Speicherzelle nach einem der Ansprüche 1 bis 7, wobei der MOS-Transistor durch eine Isolierschicht (1) isoliert ist.

9. Speicherzelle nach einem der Ansprüche 1 bis 6, bei dem der MOS-Transistor direkt auf einem Substrat des Leitfähigkeitstyps ausgebildet ist, der dem seiner Drain / Source entgegengesetzt ist.

10. Speicherzelle, gebildet aus einem MOS-Transistor mit einer Drain (8), einer Source (7) und einem Body-Bereich, der mit einem isolierten Gate (12) beschichtet ist, wobei der Body-Bereich in seiner Dicke in zwei unterschiedliche Kanalbereiche unterteilt ist (41, 43), die durch einen Isolierschichtabschnitt (42) getrennt sind, der sich parallel zur Ebene des Gates erstreckt, wobei der Body-Bereich einen dritten Kanalbereich (45) aufweist, der von den beiden zuvor genannten unterschiedlichen Kanalbereichen durch einen Isolierschichtabschnitt getrennt ist, der sich parallel zur Ebene des Gates erstreckt und im Wesentlichen die gleiche Ausdehnung wie der Isolierschichtabschnitt hat, der sich zwischen den zwei ersten unterschiedlichen Bereichen erstreckt, und wobei ein zweites Gate (3) gegenüber dem dritten unterschiedlichen Bereich entgegengesetzt zu dem ersten Gate angeordnet ist.

11. Verfahren zur Verwendung einer Speicherzelle nach einem der Ansprüche 1 bis 9, wobei die Source-Spannung als Referenzspannung betrachtet wird und der Source-Bereich (7) und der Drain-Bereich (8) vom N-Typ sind, wobei das Verfahren in beliebiger Reihenfolge die folgenden Schritte aufweist:
Schreiben einer 1: Anlegen einer positiven ersten Spannung an den Drain (8) und während eines Teils des Anlegens dieser positiven ersten Spannung Anlegen einer positiven zweiten Spannung an das Gate (12),
Schreiben einer 0: Anlegen einer dritten Spannung, die sehr schwach positiv, gleich Null oder negativ ist, an den Drain und Anlegen einer positiven vierten Spannung an das Gate,
Lesen: Anlegen einer negativen fünften Spannung an das Gate und einer niedrigen positiven sechsten Spannung an den Drain und
Aufrechterhalten: Anlegen einer negativen siebten Spannung an das Gate und einer achten Spannung, die positiv oder gleich Null ist, an den Drain.

12. Verfahren zur Verwendung einer Speicherzelle mit vier Zuständen nach Anspruch 10, wobei die Source-Spannung als Referenzspannung betrachtet wird und der Source-Bereich (7) und der Drain-Bereich (8) vom N-Typ sind, wobei das Verfahren in beliebiger Reihenfolge die folgenden Schritte aufweist:
Schreiben eines Zustands (11): Anlegen einer positiven ersten Spannung an den Drain (8) und während eines Teils des Anlegens dieser positiven ersten Spannung Anlegen einer positiven zweiten Spannung an die beiden Gatter,
Schreiben eines Zustands (00): Anlegen einer dritten Spannung, die sehr schwach positiv, gleich Null oder negativ ist, an den Drain (8) und Anlegen einer positiven vierten Spannung an die beiden Gatter,
Schreiben eines Zustands (01) oder (10): Anlegen einer positiven fünften Spannung an den Drain und während eines Teils des Anlegens dieser positiven Spannung Anlegen einer positiven sechsten Spannung an eines der Gates, dann Anlegen einer siebten Spannung, die sehr schwach positiv, gleich Null oder negativ ist, an den Drain (8) und Anlegen einer positiven achten Spannung an das andere Gate,
Lesen: Anlegen einer negativen Spannung an die Gates und einer schwach positiven neunten Spannung an den Drain und
Aufrechterhalten: Anlegen einer negativen zehnten Spannung an die Gates und einer elften Spannung, die schwach positiv oder gleich Null ist, an den Drain (8).

## Claims

1. Memory element composed of a MOS transistor having a drain (8), a source (7), and a body region covered with an insulated gate (12), wherein the body region is divided in its thickness into two distinct channel regions (13, 14) which are separated by an insulating layer portion (16) extending parallel to the plane of the gate, the channel region (13) closest to the gate (12) having a thickness of from 5 to 50 nm, preferably from 5 to 20 nm.

2. Memory element according to claim 1, wherein the two distinct regions (13, 14) are of the same type of conductivity.

3. Memory element according to claim 1, wherein the two distinct regions (13, 14) are of opposite types of conductivity.

4. Memory element according to claim 1, produced on the basis of a SOI structure.

5. Memory element according to claim 1, produced on the basis of a FINFET structure.

6. Memory element according to any one of claims 1 to 5, wherein the insulating layer portion (16) has a thickness of approximately from 1 to 10 nanometres, preferably from 1 to 3 nanometres.

7. Memory element according to any one of claims 1 to 6, further comprising a second insulated gate beneath the body region.

8. Memory element according to any one of claims 1 to 7, wherein the MOS transistor is insulated by an insulating layer (1).

9. Memory element according to any one of claims 1 to 6, wherein the MOS transistor is formed directly on a substrate of the type having opposite conductivity to that of its drain/source.

10. Memory element composed of a MOS transistor having a drain (8), a source (7), and a body region covered with an insulated gate (12), wherein the body region is divided in its thickness into two distinct channel regions (41, 43) which are separated by an insulating layer portion (42) extending parallel to the plane of the gate, wherein the body region comprises a third channel region (45) which is separated from the two distinct channel regions mentioned above by an insulating layer portion (44) extending parallel to the plane of the gate and having substantially the same extent as the insulating layer portion extending between the two first distinct regions, and wherein a second gate (3) is arranged facing the third distinct region, opposite the first gate.

11. Method of using a memory element according to any one of claims 1 to 9, wherein the source voltage is considered as the reference voltage and the source region (7) and the drain region (8) are of N-type, said method comprising, in any order, the following steps:
writing of a 1: application of a first positive voltage to the drain (8) and, during part of the application of this first positive voltage, application of a second positive voltage to the gate (12),
writing of a 0: application of a third very slightly positive, zero or negative voltage to the drain, and application of a fourth positive voltage to the gate,
reading: application of a fifth negative voltage to the gate and of a sixth positive voltage to the drain, and
retention: application of a seventh negative voltage to the gate and of an eighth positive or zero voltage to the drain.

12. Method of using a four-state memory element according to claim 10, wherein the source voltage is considered as the reference voltage and the source region (7) and the drain region (8) are of N-type, the method comprising, in any order, the following steps:
writing of a state (11): application of a first positive voltage to the drain (8) and, during part of the application of this first positive voltage, application of a second positive voltage to the two gates,
writing of a state (00): application of a third very slightly positive, zero or negative voltage to the drain (8), and application of a fourth positive voltage to the two gates,
writing of a state (01) or (10): application of a fifth positive voltage to the drain and, during part of the application of this positive voltage, application of a sixth positive voltage to one of the gates, then application of a seventh very slightly positive, zero or negative voltage to the drain (8) and application of an eighth positive voltage to the other gate,
reading: application of a negative voltage to the gates and of a ninth positive voltage to the drain, and
retention: application of a tenth negative voltage to the gates and of an eleventh slightly positive or zero voltage to the drain (8).
